# EUROPEAN PATENT SPECIFICATION

(11) **EP 1 079 447 B1**
(45) Date of publication and mention of the grant of the patent: **10.05.2006**
(21) Application number: 00306898.8
(22) Date of filing: 11.08.2000
(51) Int. Cl.: H01L 41/04

(54) **Piezo-electric/electrostrictive element driving circuit**
Ansteuerschaltung für piezoelektrische/elektrostriktive Bauelemente
Circuit de commande pour éléments piézoélectriques/électrostrictifs

(30) Priority: 20.08.1999 JP 23444799
(43) Date of publication of application: 28.02.2001
(73) Proprietor: NGK INSULATORS, LTD., Nagoya-City, Aichi Pref. 467-8530 (JP)
(72) Inventor: Takeuchi, Yukihisa, c/o NGK Insulators, Ltd., Nagoya-shi, Aichi-ken 467-8530 (JP); Ohwada, Iwao c/o NGK Insulators, Ltd., Nagoya-shi, Aichi-ken 467-8530 (JP)
(74) Representative: Paget, Hugh Charles Edward

(56) References cited:
- EP-A- 0 054 703
- DE-A- 19 714 616

## Description

### FIELD OF THE INVENTION

The present invention relates to a piezo-electric/electrostrictive element driving circuit arrangement. Such elements may be used as an actuator, transducer, various vibrators, in a micro-machine, and the like.

### RELATED ART

In an actuator, transducer, vibrator or micro-machine having a driving piezo-electric element or electrostrictive element (piezo-electric/electrostrictive element), for example, the piezo-electric/electrostrictive element is charged and discharged so as to be deformed, and shift and movement are obtained by utilizing this deformation. In a driving circuit by which the piezo-electric/electrostrictive element is charged and discharged, if discharging electric charges are discharged as Joule heat by resistance or the like, the power consumption becomes large and the calorific value becomes large. For this reason, the discharging electric charges are prevented from being discharged as heat as much as possible and they are recovered so as to be utilized as next charging power, and the power consumption is reduced.

For example in Japanese Patent No. 2909150, a plurality of piezo-electric elements are actuated at different timings so that discharging electric charges of the piezo-electric elements are directly used for charging another piezo-electric elements. As a result, an energy, which is consumed as heat by exchanging the electric charges between the piezo-electric elements, is reduced. Moreover, Japanese Patent Application Laid-Open No. 10-107335 (1998) discloses a circuit in which a capacitor which is for the exclusive use of recovery of the charging electric charges is provided, and some discharging electric charges of the piezo-electric elements are stored once in this capacitor so as to be utilized for next charging. Further, this circuit is configured so that a coil is provided in a charging/discharging circuit and a recovered electric charge amount and reused electric charge amount are made to be larger by LC resonance.

However, in the case where a plurality of piezo-electric elements are provided and the electric charges are exchanged between the piezo-electric elements, the power recovery efficiency is 50 % at most. In the case where the capacitor which is for the exclusive use of recovery is provided, when a coil is provided, the power recovery efficiency can be raised to about 90 % maximally, but since this circuit requires an external capacitor, it is not suitable for miniaturization. It is conceivable that the two structures are combined and a structure, in which a coil is provided to the circuit where the electric charges are exchanged between the piezo-electric elements, is obtained. However, simply with this structure, the charging/discharging timing between the piezo-electric elements is restricted, and it is difficult to optimize the charging/discharging waveform.

EP-A-54073 shows in its Fig. 5 a charging/discharging circuit for two piezoelectric elements. During discharging of one element, the charge is used to charge the other element, by connection through an inductance.

DE-A-19714616 illustrates in its Fig. 9 a circuit in which transistor switches are employed for controlling the charging and discharging of a piezoelectric element. It is mentioned that the transistors act as controllable ohmic resistors for the charge current and for the discharge current, to allow exact control of the charging process and the discharging process. It is also stated that the charge current and the discharge current flowing through these transistors produce substantial power losses, which causes extensive heating of the transistors, which is disadvantageous.

### SUMMARY OF THE INVENTION

The present invention has been devised from the above viewpoint. It is an object of the present invention to provide a piezo-electric element driving circuit in which a power recovery efficiency is high, namely, a power consumption is small, a degree of freedom of charging/discharging timing is high and external elements such as a capacitor for recovering a power are not required.

The invention provides a piezo-electric/electrostrictive element driving circuit, as set out in claim 1.

### BRIEF DESCRIPTION OF THE DRAWINGS

FIG. 1 is a circuit diagram of a piezo-electric/electrostrictive driving circuit according to an embodiment of the present invention.
FIGS. 2 show operating characteristics of the driving circuit in FIG. 1: FIGS. 2(a) and 2(b) are applied voltage characteristic charts of the piezo-electric/electrostrictive element; and FIG. 2(c) is an operating chart of respective switches.

### DETAILED DESCRIPTION OF THE INVENTION

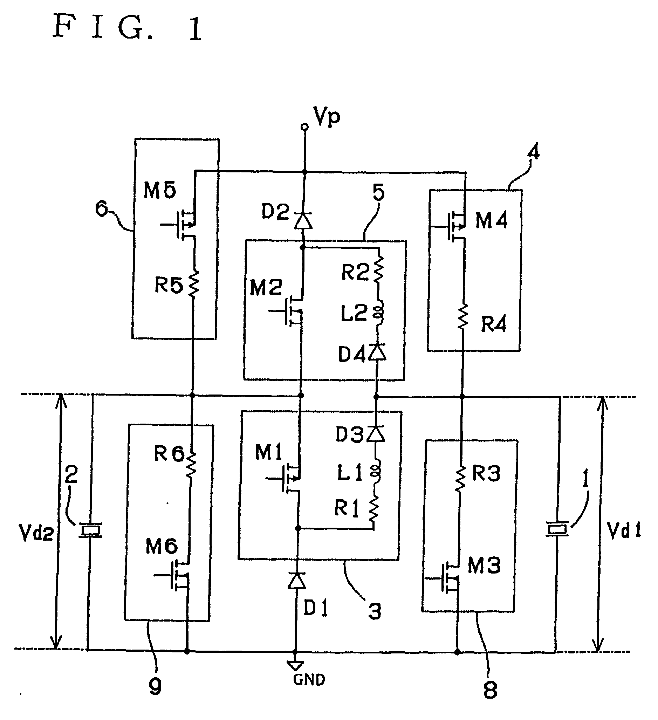

There will be detailed below an embodiment of the present invention with reference to the drawings. FIG. 1 shows a piezo-electric/electrostrictive element driving circuit of the present invention. 1 is a first piezo-electric/electrostrictive element, 2 is a second piezo-electric/electrostrictive element, M1 through M6 are switches composed of MOS type FET, and Vp is a power-supply voltage.

The switch M1 is a control switch of a first charging circuit 3 for first charging the first piezo-electric/electrostrictive element 1, and the switch M4 is a control switch of a second charging circuit 4 for finally charging the first piezo-electric/electrostrictive element 1. The switch M2 is a control switch of a third charging circuit 5 for first changing the second piezo-electric/electrostrictive element 2, and the switch M5 is a control switch of a fourth charging circuit 6 for finally charging the second piezo-electric/electrostrictive element 2. Both the piezo-electric/electrostrictive elements have two steps of the charging circuits.

In addition, the first charging circuit 3 serves also as a discharging circuit for first discharging the second piezo-electric/electrostrictive element 2, and the third charging circuit 5 serves also as a discharging circuit for first discharging the first piezo-electric/electrostrictive element 1. Namely, some or most of the electric charges, which are charged into the second piezo-electric/electrostrictive element 2, become charging electric charges of the first piezo-electric/electrostrictive element. Some or most of the electric charges, which are charged into the first piezo-electric/electrostrictive element 1, become charging electric charges of the second piezo-electric/electrostrictive element 2.

Further, the switch M3 is a control switch of a first discharging circuit 8 for completely discharging the first piezo-electric/electrostrictive element 1, and the switch M6 is a control switch of a second discharging circuit 9 for completely discharging the second piezo-electric/electrostrictive element.

Resistances R1 through R6 with capacitances C1 or C2 of the first or second piezo-electric/electrostrictive elements 1 or 2 determine charging/discharging curves with respect to time. The charging curve of the first piezo-electric/electrostrictive element 1 is determined by a characteristic due to the capacitance C1, the resistance R1 and a coil L1 and a characteristic due to the capacitance C1 and the resistance R4, and the discharging curve is determined by a characteristic due to the capacitance C1, the resistance R2 and a coil L2 and a characteristic due to the capacitance C1 and the resistance R3. Moreover, the charging curve of the second piezo-electric/electrostrictive element 2 is determined by a characteristic due to the capacitance C2, the resistance R2 and the coil L2 and a characteristic due to the capacitance C2 and the resistance R5, and the discharging curve is determined by a characteristic due to the capacitance C2, the resistance R1 and the coil L1 and a characteristic due to the capacitance C2 and the resistance R6. The charging time and discharging time of the respective piezo-electric/electrostrictive elements are determined by the above characteristics.

The coil L1 is provided to the first charging circuit 3 in a series with the resistance R1, and the coil L2 is provided to the third charging circuit 5 in a series with the resistance R2. The coils and the capacitances C1 or C2 of the piezo-electric/electrostrictive elements form an LC resonance circuit.

The switches M1, M4 and M5 are formed by P-MOS, and the switches M2, M3 and M6 are formed by N-MOS, and they are brought into the on/off state by a microcomputer, not shown. Moreover, D1 through D4 are diodes for preventing reverse current.

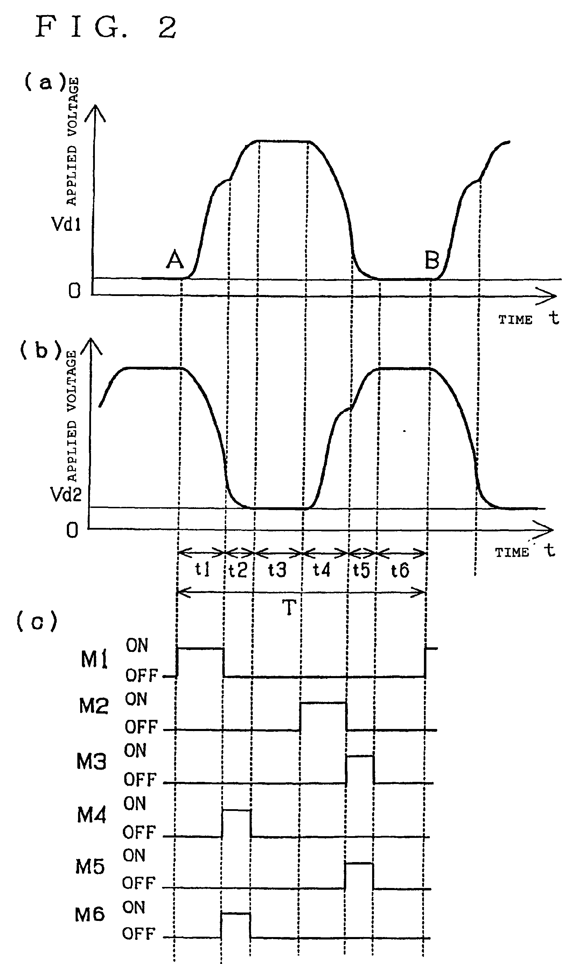

FIGS. 2 show operating characteristics of the driving circuit, FIGS. 2(a) and (b) show applied voltage waveform of the first and second piezo-electric/electrostrictive elements 1 and 2, and FIG. 2(c) shows the on/off operation of the respective switches. The explanation will be given in the case where a point A is a starting point. t1 is first charging time that the switch M1 is turned on so as to operate the first charging circuit 3 and the charged electric charges of the second piezo-electric/electrostrictive element 2 are discharged so as to charge the first piezo-electric/electrostrictive element 1. Since the circuit has the coil L1, a moved electric charge amount at this time can be not less than 50 % of a final charged electric charge amount of the second piezo-electric/electrostrictive element 2 due to the LC resonance effect.

t2 is second charging time that the switch M1 is turned off, and the switches M4 and M6 are turned on so as to finally charge the first piezo-electric/electrostrictive element 1 to a voltage close to the power-supply voltage Vp and to completely discharge the second piezo-electric/electrostrictive element 2. Here, time constant C1 × R4 and time constant C2 × R6 may obtain the different values, and t2 can be determined independently and may be different between the first and second piezo-electric/electrostrictive elements. Since t2 can be determined independently, the charging/discharging curves of the first and second piezo-electric/electrostrictive elements can be set without restricting each other.

t3 is holding time for holding a state, t4 is third charging time that the switch M2 is turned on so as to operate the third charging circuit 5 and the charged electric charges of the first piezo-electric/electrostrictive element 1 are discharged so as to charge the second piezo-electric/electrostrictive element 2. Since this circuit has the coil L2, a moved electric charge amount can be not less than 50 % of a finally charged electric charge amount of the first piezo-electric/electrostrictive element due to the LC resonance effect.

t5 is fourth charging time that the switch M5 is turned on so as to finally charge the second piezo-electric/electrostrictive element 2, and the switch M3 is turned on so as to completely discharge the first piezo-electric/electrostrictive element 1. Here, time constant C2 × R5 and time constant C1 × R3 may obtain different values, and t5 can be determined independently and may be different between the first and second piezo-electric/electrostrictive elements. Since the charging time t5 can be determined independently, the charging/discharging curves of the first and second piezo-electric/electrostrictive elements can be set without restricting each other.

t6 is holding time for holding a state, and after the holding time t6 the time reaches the ending point B so that one period is completed. Thereafter, the above switching operations are repeated, and a period T repeats in the applied voltage waveform.

In such a manner, the piezo-electric/electrostrictive elements which operate alternatively are provided so as to form the charging circuit and the discharging circuit of the piezo-electric/electrostrictive elements at two steps. For this reason, even if the electric charges are moved mutually and the power consumption is reduced, the driving waveforms of the rising time, the falling time and the like of the applied voltage of the piezo-electric/electrostrictive elements can have a degree of freedom. As a result, the optimal applied voltage waveform can be formed.

In addition, the coils are provided so that the power recovery efficiency can be improved, and an external capacitor is not required. As a result, the circuit can be miniaturized so as to be suitable particularly for the driving circuit of a micro machine and the like.

Further, the time constant at the time of charging and discharging other than the time that the first and third charging circuits operate can obtain different values independently in the first and second piezo-electric/electrostrictive elements. For this reason, a degree of freedom of the charging/discharging timing can be heightened, and the optimized waveforms can be easily formed for the respective elements. Moreover, when this circuit is adopted into an actuator, the actuator can be moved at high speed without ringing, and in micro machine, transducer and various vibrators, an external capacitor is not required and the circuit operates while recovering the electric power. For this reason, the circuit can be miniaturized easily.

In this embodiment, the coils are provided respectively to the first and third charging circuits, but the coil may be additionally provided to another charging circuit or discharging circuit according to a target voltage waveform.

Moreover, the charging and discharging circuits are formed at two steps, but a number of steps may be increased, a number of steps may be different between the charging circuit and the discharging circuit.

Further, the switches are formed by MOS type FET, but the switches are not limited to this, and they may be formed by transistors. The two piezo-electric/electrostrictive elements are provided, but a plurality of piezo-electric elements and/or a plurality of electrostrictive elements may be operated alternatively.

As detailed above, according to the invention from a first aspect, the charging and discharging waveforms are plural-steps waveforms, and charging/discharging curves other than the first-step charging waveform and discharging waveform can be set independently. For this reason, a degree of freedom of the charging/discharging timing is high, and the optimal waveforms of the piezo-electric/electrostrictive elements can be formed easily. Moreover, the coils are provided so that the power recovery efficiency can be improved. Further, since an external capacitor is not required, the circuit can be miniaturized, and this circuit is suitable for driving circuits of actuator, transducer, various vibrators, micro machine and the like which require miniaturization.

## Claims

1. A piezo-electric/electrostrictive element driving circuit, for first and second piezo-electric/electrostrictive elements (1, 2) which operate alternatingly, having
a plurality of step charging circuits (3, 4) for charging said first element (1) in a plurality of charging steps,
a plurality of step charging circuits (5, 6) for charging said second element (2) in a plurality of charging steps,
a plurality of step discharging circuits (5, 8) for discharging said first element (1) in a plurality of discharging steps, and
a plurality of step discharging circuits (3, 9) for discharging said second element (2) in a plurality of discharging steps,
wherein:
at least the first-step charging circuit (3) of said step charging circuits (3, 4) for charging said first element (1) includes, in series with said first element (1), at least one resistance (R1) and at least one coil (L1), and acts as the first-step discharging circuit (3) of said discharging circuits (3, 9) for discharging said second element (2), and
at least the first-step charging circuit (5) of said step charging circuits (5, 6) for charging said second element (2) includes, in series with said second element (2), at least one resistance (R2) and at least one coil (L2), and acts as the first-step discharging circuit (5) of said step discharging circuits (5, 8) for discharging said first element (1),
whereby discharging electric charge of one element is used directly as charging electric charge of the other element.

## Patentansprüche

1. Piezoelektrische/elektrostriktive Elementansteuerschaltung für ein erstes und ein zweites piezoelektrisches/elektrostriktives Element (1, 2), die alternierend arbeiten, mit
einer Vielzahl an Mehrstufen-Ladeschaltungen (3, 4) zum Laden des ersten Elements (1) in einer Vielzahl an Ladestufen,
einer Vielzahl an Mehrstufen-Ladeschaltungen (5, 6) zum Laden des zweiten Elements (2) in einer Vielzahl an Ladestufen,
einer Vielzahl an Mehrstufen-Entladeschaltungen (5, 8) zum Entladen des ersten Elements (1) in einer Vielzahl an Entladestufen, und
einer Vielzahl an Mehrstufen-Entladeschaltungen (3, 9) zum Entladen des zweiten Elements (2) in einer Vielzahl an Entladestufen,
worin
zumindest die Erststufen-Ladeschaltung (3) der Mehrstufen-Ladeschaltungen (3, 4) zum Laden des ersten Elements (1) zumindest einen Widerstand (R1) und zumindest eine Spule (L1), die mit dem ersten Element (1) in Reihe geschaltet sind, umfasst und als Erststufen-Entladeschaltung (3) der Entladeschaltungen (3, 9) zum Entladen des zweiten Elements (2) arbeitet, und
zumindest die Erststufen-Ladeschaltung (5) der Mehrstufen-Ladeschaltungen (5, 6) zum Laden des zweiten Elements (2) zumindest einen Widerstand (R2) und zumindest eine Spule (L2), die mit dem zweiten Element (2) in Reihe geschaltet sind, umfasst und als Erststufen-Entladeschaltung (5) der Mehrstufen-Entladeschaltungen (5, 8) zum Entladen des ersten Elements (1)arbeitet,
wodurch die elektrische Entladungsladung eines Elements direkt als elektrische Ladeladung des anderen Elements verwendet wird.

## Revendications

1. Circuit de commande pour éléments piézo-électriques/électrostrictifs, pour des premier et deuxième éléments piézo-électriques/électrostrictifs (1, 2) qui fonctionnent alternativement, comprenant :
une pluralité de circuits de charge par étapes (3, 4) pour charger ledit premier élément (1) en une pluralité d'étapes de charge ;
une pluralité de circuits de charge par étapes (5, 6) pour charger ledit deuxième élément (2) en une pluralité d'étapes de charge ;
une pluralité de circuits de décharge par étapes (5, 8) pour décharger ledit premier élément (1) en une pluralité d'étapes de décharge ; et
une pluralité de circuits de décharge par étapes (3, 9) pour décharger ledit deuxième élément (2) en une pluralité d'étapes de décharge ;
dans lequel :
au moins le premier circuit de charge par étapes (3) desdits circuits de charge par étapes (3, 4) pour charger ledit premier élément (1) comprend, en série avec ledit premier élément (1), au moins une résistance (R1) et au moins une bobine (L1), et agit comme le premier circuit de décharge par étapes (3) desdits circuits de décharge par étapes (3, 9) pour décharger ledit deuxième élément (2) ; et
au moins le premier circuit de charge par étapes (5) desdits circuits de charge par étapes (5, 6) pour charger ledit deuxième élément (2) comprend, en série avec ledit deuxième élément (2), au moins une résistance (R2) et au moins une bobine (L2), et agit comme le premier circuit de décharge par étapes (5) desdits circuits de décharge par étapes (5, 8) pour décharger ledit deuxième élément (1) ;
moyennant quoi une charge électrique de décharge de l'un des éléments est utilisée directement comme une charge électrique de charge de l'autre élément.
